# EUROPÄISCHE PATENTSCHRIFT

(11) **EP 1 176 599 B1**
(45) Veröffentlichungstag und Bekanntmachung des Hinweises auf die Patenterteilung: **19.11.2003**
(21) Anmeldenummer: 01114679.2
(22) Anmeldetag: 19.06.2001
(51) Int. Cl.: G11C 7/22, G11C 11/406, G11C 11/4074, G11C 7/06, G11C 5/14

(54) **Schaltungsanordnung zum Umschalten einer Receiverschaltung insbesondere in DRAM-Speichern**
Circuit device for switching a receiver circuit, especially in DRAM memories
Circuit pour commuter un circuit récepteur, en particulier dans une mémoire DRAM

(30) Priorität: 03.07.2000 DE 10032236
(43) Veröffentlichungstag der Anmeldung: 30.01.2002
(73) Patentinhaber: Infineon Technologies AG, 81669 München (DE)
(72) Erfinder: Brass, Eckhard, 82008 Unterhaching (DE); Le, Thoai-Thai, 81737 München (DE); Lindolf, Jürgen, 86316 Friedberg (DE); Schnabel, Joachim, 81549 München (DE)
(74) Vertreter: Müller - Hoffmann & Partner

(56) Entgegenhaltungen:
- US-A- 4 804 865
- ITOH K ET AL: "TRENDS IN LOW-POWER RAM CIRCUIT TECHNOLOGIES" PROCEEDINGS OF THE IEEE, IEEE. NEW YORK, US, Bd. 83, Nr. 4, 1. April 1995 (1995-04-01), Seiten 524-543, XP000507211 ISSN: 0018-9219

## Beschreibung

Die Erfindung betrifft eine Schaltungsanordnung zum Umschalten einer Receiverschaltung insbesondere in DRAM-Speichern zwischen einem Standby-Modus und einem Arbeits-Modus, wobei für jeden als Receiver fungierenden Differenzverstärker eine aus einem Referenzstrom abgeleitete Steuerspannung zur Einstellung seines richtigen Arbeitspunkts erzeugt oder zugeführt wird.

Besonders für Laptop- oder Notebook-Anwendungen ist es erforderlich, daß die darin enthaltenen Speicherbausteine insbesondere DRAM-Speicherbausteine auch im Power-Down- oder Standby-Modus einen geringen Stromverbrauch haben. Im Speicherbaustein fungieren Differenzverstärker als Receiver, die zur Einstellung ihres richtigen Arbeitspunkt eine Steuerspannung brauchen. Bei existierenden DRAM-Speicherbausteinen wird die Steuerspannung aus einem Referenzstrom erzeugt, der über Stromspiegel verteilt wird. Während im Power-Down- bzw. Standby-Modus die Receiver abgeschaltet werden können, dürfen die verteilten Ströme nicht ausgeschaltet werden, damit die Receiver bei einer Reaktivierung des Speicherchips im Arbeitsmodus sofort, d. h. möglichst in einem Taktzyklus, wieder verfügbar sind.

Dies bedingt, daß durch die bekannten Speicherchips, während sie im Standby-Modus verharren, ständig ein Standby-Strom fließt, der nicht zu vernachlässigen ist und der, wenn ein Laptop oder Notebook batteriebetrieben ist, die Batterie dauerhaft belastet. Die durch Stromspiegel verteilten Strompfade könnten durch jeweils einen Schalttransistor, der in den einzelnen den Strom den Receivern zuführenden Leitungen liegt, im Standby-Modus abgeschaltet werden. Wie jedoch oben bereits erwähnt, darf die Steuerspannung der Receiver im Standby-Modus jedoch nicht abgeschaltet werden, da die Receiver sonst beim Umschalten in den Arbeitsmodus möglicherweise nicht schnell genug reaktiviert werden können.

Die US 5,557,221 A (Spalten 1 bis 16, Figurenblätter 1 bis 8) beschreibt und zeigt, insbesondere in Fig. 8, eine Schaltungsanordnung zum Umschalten einer Receiverschaltung, bei der in Abhängigkeit von einer am Eingang anliegenden Frequenz oder Amplitude zwischen einem ersten Arbeitsmodus und einem zweiten stromsparenden Modus umgeschaltet wird.

Aus der US 5,920,208 A ist eine Umschaltvorrichtung für einen Semseamplifier bekannt, mit der eine Beendigung des Lesevorgang mittels eines Datenvergleiches erfaßt und eine Umschaltung in den Power-down-Modus ausgeführt wird.

Es ist deshalb Aufgabe der Erfindung, die obigen Nachteile bei der bislang üblichen Umschaltung zwischen Standby- oder Power-Down-Modus und Arbeitsmodus zu vermeiden und eine Schaltungsanordnung anzugeben, die die Steuerspannung der Receiver auch im Standby- oder Power-Down-Modus mit reduziertem Standby-Strom so aufrechterhält, daß die Receiver beim Übergang in den Arbeitsmodus hinreichend schnell, z. B. innerhalb weniger Nanosekunden, aktivierbar sind.

Die obige Aufgabe wird anspruchsgemäß gelöst.

Gemäß einem wesentlichen Aspekt der Erfindung ist eine gattungsgemäße Schaltungsanordnung dadurch gekennzeichnet, daß für jeden Receiver Schaltglieder in einer einen Strom zur Erzeugung der Steuerspannung zuführenden Leitung vorgesehen sind, die im Arbeitsmodus durch ein den Schaltgliedern anliegendes Freigabesignal dauernd geschlossen sind, um den Strom zur Erzeugung der Steuerspannung kontinuierlich zu liefern und im Standby-Modus in diskreten Zeiten oder periodisch durch Zufuhr eines Refreshsignals geschlossen werden, um die Steuerspannung aufzufrischen.

Somit wird mit der vorliegenden erfindungsgemäßen Schaltungsanordnung die Steuerspannung für die als Receiverschaltung fungierenden Differenzverstärker diskontinuierlich oder periodisch aufgefrischt. Auf diese Weise wird der Standby-Strom für die Receiver erheblich reduziert. Besonders bei DRAM-Speichern kann ein separater Generator für ein periodisches Refreshsignal zum Einschalten der Schaltglieder entfallen, wenn, wie bevorzugt, das Selfrefreshsignal des DRAM-Speichers verwendet wird. Selbstverständlich kann jedoch auch ein von dem Selfrefreshsignal abgeleitetes Einschaltsignal für die Schaltglieder verwendet werden, dessen Periode ein Mehrfaches der Selfrefreshperiode beträgt.

Zur Stabilisierung der diskontinuierlich oder periodisch den Receivern zugeführten Steuerspannung können jedem Receiver zugeordnete Stützkondensatoren zur Verlängerung der Refreshzeit eingesetzt werden.

Nachstehend wird ein bevorzugtes Ausführungsbeispiel einer erfindungsgemäßen Schaltungsanordnung bezogen auf die Zeichnungsfigur beschrieben.

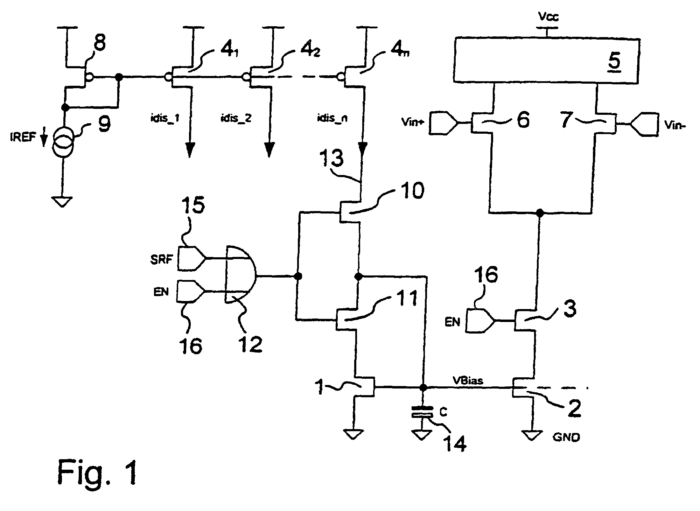

Die Fig. 1 zeigt schematisch eine mögliche Realisierung der erfindungsgemäßen Schaltungsanordnung. Ein Differenzverstärker 6, 7 bildet einen Receiver für eine Last 5, dessen Arbeitspunkt durch eine Steuerspannung definiert ist, die aus einem von einem Stromspiegeltransistor 2 über einen Freigabetransistor 3 fließenden Strom erzeugt wird. Der Freigabetransistor 3 wird von einem Freigabesignal (EN) 16 im Arbeitsmodus geschlossen. Die Stärke des von der Stromquelle 2 fließenden Stroms wird durch eine Referenzspannung V_{BIAS} bestimmt, die im Standby-Modus durch die Ladung eines Stützkondensators 14 bestimmt ist. Der Stützkondensator 14 mit der Kapazität C wird im Standby in der nachstehend beschriebenen Weise periodisch oder diskontinuierlich durch einen durch eine Zuleitung 13 fließenden Strom Idis_n aufgeladen. Dieser Strom Idis_n stammt aus einer Stromspiegelschaltung, die aus Stromspiegeltransistoren 41, 42, ..., 4n, einem Transistor 8 und einer Referenzstromquelle 9, durch die der Referenzstrom IREF fließt, besteht.

Damit die Receiver bei der Reaktivierung des Chips im Arbeitsmodus innerhalb weniger Nanosekunden wieder zur Verfügung stehen, wird, wie erwähnt, im Standby-Modus die Steuerspannung für den Differenzverstärker 6, 7 der Ladung des Stützkondensators 14 entnommen.

Erfindungsgemäß sind Schaltglieder 10, 11, 12 in der Zuleitung 13 zur Erzeugung der Referenzspannung V_{BIAS} vorgesehen. Die Schaltglieder 10 und 11 sind bevorzugt MOS-Transistoren, und das Schaltglied 12 bildet ein ODER-Glied, das im Standby-Betrieb ein periodisches oder diskontinuierliches Refreshsignal SRF 15 und im Arbeits-Modus das Freigabesignal (EN) 16 empfängt.

Weiterhin ist der Stützkondensator 14 so ausgelegt, daß er die Referenzspannung V_{BIAS} stabilisieren und damit die Refreshzeit verlängern kann.

Während "Power-Down", d.h. im Standby-Modus (EN = 0) werden die MOS-Transistoren 10, 11 nur im Refreshzyklus (SRF periodisch oder diskontinuierlich gleich 1) aktiviert und schalten den über die Leitung 13 zugeführten Strom zum Transistor 1.

Im Falle eines DRAM-Speichers kann das Refreshsignal 15 das im Speicher ohnehin vorhandene periodische Selfrefreshsignal sein. Damit kann ein Generator zur Erzeugung des Refreshsignals 15 entfallen.

Selbstverständlich kann die Refreshperiode auch ein Mehrfaches der Selfrefreshperiode sein.

In anderen Anwendungsfällen kann das Refreshsignal 15 auch nichtperiodisch sein, solange die Kapazität des Stützkondensators 14 ausreichend groß ist um die längste Zeitdauer zwischen zwei aufeinanderfolgenden Refreshsignalen zu überbrücken.

Mit der oben beschriebenen und in der Figur dargestellten Ausführungsform einer erfindungsgemäßen Schaltungsanordnung läßt sich der Standby-Strom im Power-Down- oder Standby-Modus wesentlich reduzieren und dennoch die Receiver beim Umschalten in den Arbeitsmodus sehr schnell reaktivieren.

Selbstverständlich ist die erfindungsgemäße Schaltungsanordnung nicht nur in DRAM-Speichern anwendbar sondern auch in anderen Anordnungen bei denen eine Reduktion des im Standby-Modus durch Receiver fließenden Standby-Stroms wünschenswert ist.

## Patentansprüche

1. Schaltungsanordnung zum Umschalten einer Receiverschaltung, insbesondere in DRAM-Speichern, zwischen einem Standby-Modus und einem Arbeits-Modus, wobei für jeden als Receiver fungierenden Differenzverstärker (6, 7) eine aus einem Referenzstrom (IREF) abgeleitete Steuerspannung zur Einstellung seines richtigen Arbeitspunkts erzeugt oder zugeführt wird,
**dadurch gekennzeichnet, daß** für jeden Receiver (6, 7) Schaltglieder (10, 11, 12) in einer einen Strom (idis_n) zur Erzeugung der Steuerspannung zuführenden Leitung (13) vorgesehen sind, die im Arbeitsmodus durch ein den Schaltgliedern anliegendes Freigabesignal (EN) dauernd geschlossen sind, um den Strom (idis_n) zur Erzeugung der Steuerspannung kontinuierlich zu liefern, und die im Standby-Modus in diskreten Zeiten oder periodisch durch Zufuhr eines Refreshsignals (SRF) geschlossen werden, um die Steuerspannung (V_{BIAS}) diskontinuierlich aufzufrischen.

2. Schaltungsanordnung nach Anspruch 1,
**dadurch gekennzeichnet, daß** die Schaltglieder (10, 11) MOS-Schalttransistoren sind.

3. Schaltungsanordnung nach Anspruch 1 oder 2,
**dadurch gekennzeichnet, daß** das Refreshsignal (SRF) das Speicher-Selfrefreshsignal eines DRAM-Speichers oder ein Signal ist, dessen Periodendauer ein Vielfaches der Periode des Selfrefreshsignals beträgt.

4. Schaltungsanordnung nach einem der vorangehenden Ansprüche,
**dadurch gekennzeichnet, daß** sie weiterhin für jeden Receiver (6, 7) wenigstens einen Stützkondensator (14) mit einer Kapazität (C) aufweist, die zur Speicherung der Ladung durch den von den Schaltgliedern jeweils gelieferten Strom (idis_n) über eine die längste Periodendauer des Refreshsignals überschreitende Zeitdauer ausreicht.

5. DRAM-Speicher
**gekennzeichnet durch**
eine Schaltungsanordnung nach einem der Ansprüche 1 bis 4.

## Claims

1. Circuit arrangement for switching over a receiver circuit, in particular in DRAM memories, between a standby mode and an operating mode, in which case, for each differential amplifier ( 6, 7) functioning as receiver, a control voltage derived from a reference current (IREF) and serving for setting its correct operating point is generated or fed in,
**characterized in that**,
for each receiver (6, 7), switching elements (10, 11, 12) are provided in a line (13) which feeds a current (idis_n) for generating the control voltage, which, in the operating mode, are permanently closed by an enable signal (EN) present at the switching elements, in order to continuously supply the current (idis_n) for generating the control voltage, and which, in the standby mode, are closed at discrete times or periodically by the feeding of a refresh signal (SRF) in order to discontinuously refresh the control voltage (V_{BIAS}).

2. Circuit arrangement according to Claim 1,
**characterized in that**
the switching elements (10, 11) are MOS switching transistors.

3. Circuit arrangement according to Claim 1 or, 2,
**characterized in that**
the refresh signal (SRF) is the memory self-refresh signal of a DRAM memory or a signal whose period duration is a multiple of the period of the self-refresh signal.

4. Circuit arrangement according to one of the preceding claims,
**characterized in that**
it furthermore has, for each receiver (6, 7), at least one backup capacitor (14) having a capacitance (C) which suffices for storing the charge due to the current (idis_n) respectively supplied by the switching elements over a time duration which exceeds the longest period duration of the refresh signal.

5. DRAM memory,
**characterized by**
a circuit arrangement according to one of Claims 1 to 4.

## Revendications

1. Montage de commutation d'un circuit récepteur, notamment dans des mémoires DRAM, entre un mode de repos et un mode de travail, une tension de commande dérivée d'un courant (IREF) de référence étant produite ou envoyée pour chaque amplificateur (6, 7) différentiel servant de récepteur pour le réglage correct de son point de travail,
**caractérisé en ce qu'**il est prévu, pour chaque récepteur (6, 7), des éléments (10, 11, 12) de commutation dans une ligne (13) amenant un courant (idis_n) de production de la tension de commande, qui sont fermés en permanence en mode de travail par un signal (EN) de validation s'appliquant aux éléments de commutation pour fournir en continu le courant (idis_n) de production de la tension de commande et qui, en mode de repos, sont fermés pendant des durées discrètes ou périodiquement par l'envoi d'un signal (SRF) de restauration pour restaurer en discontinu la tension (V_{BIAS}) de commande.

2. Montage suivant la revendication 1,
**caractérisé en ce que** les éléments (10, 11) de commutation sont des transistors de commutation MOS.

3. Montage suivant la revendication 1 ou 2,
**caractérisé en ce que** le signal (SRF) de restauration est le signal d'auto-restauration d'une mémoire DRAM ou un signal dont la durée de la période est un multiple de la période du signal d'auto-restauration.

4. Montage suivant l'une des revendications précédentes,
**caractérisé en ce qu'**il comprend, en outre, pour chaque récepteur (6, 7) au moins un condensateur (14) d'appui d'une capacité (C) qui suffit pour l'emmagasinage de la charge par le courant (idis_n) fourni respectivement par les éléments de commutation sur une durée dépassant la durée de période la plus longue du signal de restauration.

5. Mémoire DRAM
**caractérisée par** un montage suivant l'une des revendications 1 à 4.
